(19) Europäisches Patentamt / European Patent Office / Office européen des brevets

(11) **EP 4 350 992 B1**

(12) **FASCICULE DE BREVET EUROPEEN**

(45) Date de publication et mention
de la délivrance du brevet:
**04.12.2024 Bulletin 2024/49**

(21) Numéro de dépôt: **23199475.7**

(22) Date de dépôt: **25.09.2023**

(51) Classification Internationale des Brevets (IPC):
**H03K 3/03** *(2006.01)*     **G01R 19/255** *(2006.01)*
**H03K 7/08** *(2006.01)*

(52) Classification Coopérative des Brevets (CPC):
**H03K 3/03; H03K 7/08**

(54) **CONVERTISSEUR ANALOGIQUE-DURÉE**

ANALOG-ZEIT-WANDLER

ANALOG-TO-TIME CONVERTER

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priorité: **03.10.2022 FR 2210093**

(43) Date de publication de la demande:
**10.04.2024 Bulletin 2024/15**

(73) Titulaire: **Commissariat à l'Energie Atomique et
aux Energies
Alternatives
75015 Paris (FR)**

(72) Inventeurs:
• **MOSTAFA, Ali**
  **38054 Grenoble Cedex 9 (FR)**
• **BADETS, Franck**
  **38054 Grenoble Cedex 9 (FR)**
• **HARDY, Emmanuel**
  **38054 Grenoble Cedex 9 (FR)**

(74) Mandataire: **Cabinet Beaumont
4, Place Robert Schuman
B.P. 1529
38025 Grenoble Cedex 1 (FR)**

(56) Documents cités:
**GB-A- 1 436 851**

• **GOUX NICOLAS ET AL: "A 6-nW 0.0013-mm2 ILO
Bandpass Filter for Time-Based Feature
Extraction", IEEE SOLID-STATE CIRCUITS
LETTERS, IEEE, vol. 3, 13 August 2020
(2020-08-13), pages 306 - 309, XP011808228, DOI:
10.1109/LSSC.2020.3016716**
• **CHABCHOUB EMNA ET AL: "Highly linear
voltage-to-time converter based on injection
locked relaxation oscillators", 2017 14TH
INTERNATIONAL MULTI-CONFERENCE ON
SYSTEMS, SIGNALS & DEVICES (SSD), IEEE, 28
March 2017 (2017-03-28), pages 733 - 737,
XP033276775, DOI: 10.1109/SSD.2017.8167011**

**Description**

Domaine technique

La présente description concerne de façon générale les circuits électroniques, par exemple intégrés, et, plus particulièrement les circuits de conversion d'une tension analogique en durée, ou convertisseurs analogique-durée ("analog to time converter" en anglais).

Technique antérieure

Un convertisseur analogique-durée est configurée pour convertir la valeur d'une tension analogique en une durée représentative de cette valeur, par exemple en un signal impulsionnel présentant des impulsions ayant chacune une durée représentative de la valeur de la tension convertie.

Un tel signal impulsionnel est plus robuste aux variations de tension d'alimentation, et, plus généralement aux variations PVT (de l'anglais "Process Voltage Température" - Procédé Tension Température) que la tension analogique à laquelle ce signal correspond. En outre, les circuits manipulant un tel signal impulsionnel sont quasiment entièrement numériques, qui bénéficient d'une meilleure marge de bruit, et d'une complexité, d'une consommation et d'un coût réduits par rapport aux circuits analogiques correspondants qui manipuleraient directement la tension analogique. Ainsi, les convertisseurs analogique-durée sont, par exemple, particulièrement adaptés à des mises en oeuvre dans des circuits basse consommation, comme par exemple des circuits alimentés par batterie comprenant, par exemple, des capteurs fournissant une tension à convertir.

En outre, il est possible de mettre en oeuvre des convertisseurs analogique-durée comprenant une fonction de filtrage passe bande, ce qui permet de réduire la complexité d'un circuit intégré comprenant un tel convertisseur analogique-durée à filtrage passe bande (ATC BPF de l'anglais "Analog to Time Converter Band Pass Filter").

Des convertisseurs analogique-durée à filtrage passe bande sont connus.

L'article "Time-encoding-based ultra-low power features extraction circuit for speech recognition tasks", de Gutierrez et al, Electronics (Switzerland), 9(3), présente un convertisseur analogique-durée à filtrage passe bande. Toutefois, la fréquence de résonance de ce filtre passe bande est définie par le gain de transduction et par les fréquences d'oscillation libre des oscillateurs en anneau, qui sont deux paramètres sensibles aux variations de procédé et de température. En outre, les oscillateurs en anneau contrôlés en tension souffrent de non linéarité entre la tension de commande qu'ils reçoivent et la fréquence du signal qu'ils fournissent, et peuvent en outre présenter des dispersions ("mismatch" en anglais) les uns par rapport aux autres. Cela rend le régalage du gain et/ou de la fréquence de résonnance du filtre compliqué.

L'article "A 23 $\mu$w Solar-Powered Keyword-Spotting ASIC with Ring-Oscillator-Based Time-Domain Feature Extraction" de Kim et al, IEEE Solid-State Circuits Conférence (2022) tente de limiter la dispersion de la fréquence d'oscillation libre des oscillateurs en anneaux du convertisseur de l'article précédent en utilisant des boucles à verrouillage de phase. Toutefois, cela résulte en une augmentation de la complexité et de la consommation.

L'article "A 6-nW 0.0013-mm ILO Bandpass Filter for Time-Based Feature Extraction", de Goux et al, IEEE Solid-State Circuits Letters, 3, 306-309, présente un convertisseur utilisant des oscillateurs à verrouillage en injection (ILO de l'anglais "Injection Locked Oscillator") plutôt que des oscillateurs en anneau commandés en tension. Cela permet d'éviter les dérives en fréquence avec les variations PVT dont souffrent les oscillateurs en anneau commandés en tension. En outre, la fonction de filtrage passe bande est mise en oeuvre en combinant un filtre passe bas mis en oeuvre par un oscillateur à verrouillage en injection et un filtre passe haut. Toutefois, la fonction de transfert passe bande qui en résulte ne présente pas de pôle complexe, ce qui limite le facteur de qualité du filtre passe bande à des valeurs inférieures à 0,5. En outre, le gain de conversion de cette architecture dépend de la fréquence de résonance du filtre passe bande, ce qui implique qu'il est complexe de changer la fréquence de résonance du filtre passe bande sans changer le gain de conversion.

Plus généralement, les convertisseurs analogique-durée à filtre passe bande connus présentent de nombreux inconvénients. Résumé de l'invention

Il existe un besoin de pallier tout ou partie des inconvénients des convertisseurs analogique-durée à filtre passe bande connus, ces inconvénients étant, par exemple, un faible facteur de qualité et/ou la complexité de réglage de la fréquence de résonance du filtre et/ou la dérive avec les variations PVT.

Un mode de réalisation pallie tout ou partie des inconvénients des convertisseurs analogique-durée à filtre passe bande connus.

L'invention prévoit un convertisseur d'une tension en durée, le convertisseur comprenant :

un chemin direct comprenant un premier oscillateur à verrouillage en injection et un premier circuit, le premier circuit étant configuré pour recevoir un signal de sortie du premier oscillateur et un signal de référence, et pour fournir au moins un premier signal impulsionnel déterminé par un déphasage entre le signal de sortie du premier oscillateur et le signal de référence ; et

une boucle de contre réaction comprenant un deuxième circuit configuré pour intégrer ledit au moins un premier signal impulsionnel,

dans lequel le premier oscillateur est configuré pour être commandé par un écart entre la tension à convertir et une tension de sortie de la boucle de contre réaction, la tension de sortie de la boucle de contre réaction étant déterminée par une tension de sortie du deuxième circuit représentative de l'intégration dudit au moins un premier signal impulsionnel, la boucle de contre réaction et le chemin direct étant, par exemple, configurée pour qu'un rebouclage de la boucle de contre réaction sur le chemin direct mette en oeuvre une contre réaction négative.

Selon un mode de réalisation, le premier oscillateur est un déphaseur contrôlé en tension.

Selon un mode de réalisation, ledit au moins un premier signal impulsionnel comprend des impulsions ayant chacune une durée déterminée par le déphasage entre le signal de sortie du premier oscillateur et le signal de référence.

Selon un mode de réalisation :

le premier oscillateur est configuré pour recevoir un signal périodique à une fréquence de verrouillage du premier oscillateur, et pour que ledit écart de tension détermine un déphasage entre le signal de sortie du premier oscillateur et le signal périodique.

Selon un mode de réalisation, le signal de référence et le premier circuit sont configurés pour compenser un déphasage fixe introduit par le premier oscillateur entre le signal périodique à la fréquence de verrouillage et le signal de sortie du premier oscillateur.

Selon un mode de réalisation, le convertisseur comprend un deuxième oscillateur à verrouillage en injection configuré pour recevoir le signal périodique et pour fournir le signal de référence.

Selon un mode de réalisation, le convertisseur comprend deux deuxièmes oscillateurs identiques à verrouillage en injection rebouclés l'un sur l'autre et configurés pour fournir le signal périodique et le signal de référence.

Selon un mode de réalisation :

la tension à convertir est une première composante d'un signal différentiel comprenant une deuxième composante ;

le convertisseur comprend en outre un troisième circuit identique au deuxième circuit, configuré pour intégrer ledit au moins un premier signal impulsionnel, de préférence de manière de manière complémentaire par rapport au deuxième circuit ; et

le convertisseur comprend un deuxième oscillateur à verrouillage en injection identique au premier oscillateur, le deuxième oscillateur étant configuré pour fournir le signal de référence et pour qu'une différence de tension entre la deuxième composante et une tension déterminée par une tension de sortie du troisième circuit détermine un déphasage entre le signal de référence et le premier signal périodique.

Selon un mode de réalisation :

la tension à convertir est une première composante d'un signal différentiel comprenant une deuxième composante ;

le convertisseur comprend un deuxième oscillateur à verrouillage en injection et un troisième circuit, le troisième circuit étant configuré pour recevoir un signal de sortie du deuxième oscillateur et le signal périodique, et pour fournir au moins un deuxième signal impulsionnel déterminé par un déphasage entre le signal de sortie du deuxième oscillateur et le signal périodique ;

le convertisseur comprend un quatrième circuit configuré pour intégrer ledit au moins un deuxième signal impulsionnel ; et

le deuxième oscillateur est configuré pour recevoir le signal de référence et pour qu'un déphasage entre son signal de sortie et le signal de référence soit déterminé par une différence de tension entre la deuxième composante et une tension déterminée par une tension de sortie du quatrième circuit.

Selon un mode de réalisation, le convertisseur comprend deux troisièmes oscillateurs à verrouillage en injection identiques, rebouclés l'un sur l'autre et configurés pour fournir le signal périodique et le signal de référence avec un déphasage de $\Pi/2$ par rapport au signal périodique.

Selon un mode de réalisation :

les premier et deuxième oscillateurs sont identiques ;

les premier et troisième circuits sont identiques ; et

les deuxième et quatrième circuits sont identiques.

Selon un mode de réalisation, le convertisseur est configuré pour que la fréquence de verrouillage soit au milieu d'une plage de verrouillage du premier oscillateur.

Selon un mode de réalisation :

ledit au moins un premier signal impulsionnel comprend deux premiers signaux impulsionnels ;
le premier circuit comprend un détecteur de phase configuré pour fournir les deux premiers signaux impulsionnels.

Selon un mode de réalisation, le deuxième circuit est une pompe de charge.

Selon un mode de réalisation, chaque oscillateur est un oscillateur à relaxation comprenant une bascule RS configurée pour commander des phases de charge et de décharge dans deux capacités, et pour être commander à partir des tensions aux bornes desdites deux capacités.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 représente, sous la forme de blocs, un mode de réalisation d'un convertisseur analogique-durée à filtre passe bande ;

la figure 2 représente, sous la forme de blocs, un mode de réalisation plus détaillé du convertisseur de la figure 1 ;

la figure 3 représente, sous la forme de blocs, une variante de réalisation du convertisseur de la figure 2 ;

la figure 4 représente, sous la forme de blocs, un mode de réalisation d'une partie du convertisseur des figures 1 à 3 ; et

la figure 5 représente un exemple de mise en oeuvre d'un circuit de la figure 4 ;

la figure 6 représente un exemple de mise en oeuvre d'un autre circuit de la figure 4 ;

la figure 7 représente, sous la forme de blocs, une variante de réalisation du convertisseur des figures 1 à 4 ;

la figure 8 représente un exemple de mode de réalisation d'un circuit du convertisseur des figures 1 à 4 ;

la figure 9 représente une variante de réalisation du circuit de la figure 8 ;

la figure 10 représente encore une autre variante de réalisation du circuit de la figure 8 ;

la figure 11 représente un exemple de mode de réalisation d'un circuit du convertisseur des figures 1 à 4 ;

la figure 12 représente un exemple de mode de réalisation d'un circuit du convertisseur des figures 1 à 4 ;

la figure 13 représente un mode de réalisation d'un convertisseur analogique-durée à filtre passe bande comprenant le convertisseur décrit en relation avec les figures 1 à 12 ; et

la figure 14 représente un autre mode de réalisation d'un convertisseur analogique-durée à filtre passe bande comprenant le convertisseur décrit en relation avec les figures 1 à 12.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

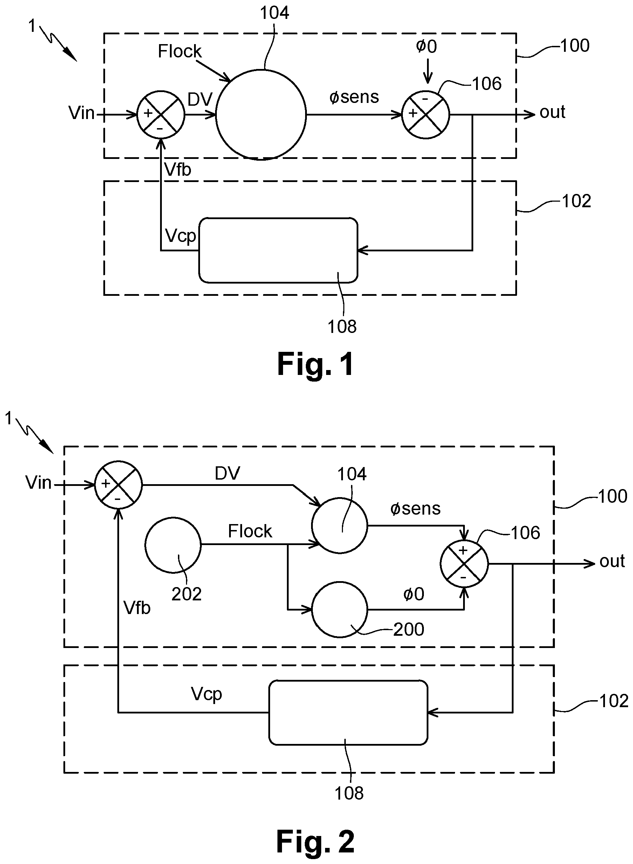

La figure 1, sous la forme de blocs, un mode de réalisation d'un convertisseur analogique-durée à filtre passe bande 1. Plus particulièrement, le convertisseur 1 est configuré pour convertir une tension Vin en durée, par exemple en convertissant la tension Vin en un ou plusieurs signaux impulsionnels out ayant des impulsions de durées déterminées par la valeur de la tension Vin. Pour simplifier la lecture de la suite de la description, l'expression "le signal out" signifie, sauf précision ou indication contraire, "le ou les signaux out".

Le convertisseur 1 comprend un chemin direct 100 (délimité par des pointillés en figure 1) et une boucle de contre réaction 102 (délimité par des pointillés en figure 1). La tension Vin est, par exemple, fournie en entrée du chemin direct 100, donc en entrée du convertisseur 1. Le signal out est par exemple fourni en sortie du chemin direct 100, donc en sortie du convertisseur 1. Le signal out est par exemple fourni en entrée de la boucle de contre réaction 102. Le chemin de retour 102 fournit par exemple un signal de sortie Vfb, ce signal Vfb étant par exemple fourni au chemin direct, par exemple pour être soustrait à la tension Vin. A titre d'exemple, le signal Vfb et le rebouclage de la contre réaction 102 sur l'entrée du chemin direct 100 sont configurés pour avoir une contre réaction négative.

Le chemin direct 100 comprend un oscillateur à verrouillage en injection 104 et un circuit 106. Le circuit 106 est configuré pour recevoir un signal Φsens de sortie de l'oscillateur 104 et un signal de référence Φ0. Le circuit 106 est en outre configuré pour fournir au moins un signal impulsionnel out déterminé par un déphasage entre le signal Φsens et le signal Φ0. Plus exactement, le signal out comprend des impulsions ayant chacune une durée déterminée par la valeur de la tension Vin. A titre d'exemple, le signal Φ0 est représentatif d'un déphasage fixe par rapport au signal Flock, par exemple égal à $\Pi/2$, permettant de supprimer un décalage de phase fixe, par exemple égal à $\Pi/2$, introduit par l'oscillateur 104 entre Flock et Φsens. Dit autrement, le signal Φ0 est configuré pour compenser un décalage de phase fixe introduit par l'oscillateur 104.

La boucle de contre réaction 102 comprend un circuit 108 configuré pour intégrer le signal out. Le circuit 108 est configuré pour fournir un signal Vcp correspondant à cette intégration, par exemple une tension Vcp dont la valeur varie avec la durée des impulsions du signal out. Le circuit 108 est, par exemple, configuré pour accumuler les largeurs des impulsions du signal out, ou, dit autrement, est un accumulateur de largeur d'impulsion. Selon un mode de réalisation, le circuit 108 comprend une pompe de charge, par exemple une pompe de charge commandées par les impulsions du signal out. Le circuit 108 étant un intégrateur, sa fonction de transfert H1 peut s'écrire $H1 = K1/s$, avec K1 le gain du circuit 108 et s la variable de Laplace, parfois également noté p au lieu de s.

Comme cela est connu de la personne du métier, un oscillateur à verrouillage en injection, par exemple l'oscillateur 104 de la figure 1, est un oscillateur qui, en l'absence d'un signal de verrouillage Flock, c'est à dire d'un signal périodique à une fréquence de verrouillage flock, fournit un signal périodique à une fréquence f0 appelée fréquence naturelle de l'oscillateur. Lorsque l'oscillateur reçoit le signal Flock, l'oscillateur se verrouille sur la fréquence flock et la fréquence du signal périodique fourni par l'oscillateur devient égale à flock, avec un décalage de phase fixe par rapport au signal Flock. A noter que la fréquence flock doit être suffisamment proche de la fréquence f0 pour que l'oscillateur se verrouille sur la fréquence flock, c'est à dire que la fréquence flock doit être dans la plage de verrouillage de l'oscillateur. En effet, la valeur du décalage fixe introduit par un oscillateur à verrouillage en injection, par exemple l'oscillateur 104, entre Flock et sa sortie (en l'absence d'une commande en tension DV) est limité à une plage donnée de valeurs allant, par exemple, de 0 à $\Pi$. Comme la valeur du décalage de phase fixe dépend de flock, choisir une valeur de flock donnée permet de fixer la valeur du décalage de phase fixe introduit par l'oscillateur 104. En particulier, selon un mode de réalisation, la fréquence flock est choisie au milieu de la plage de verrouillage de l'oscillateur 104, ce qui permet que le convertisseur 1 ait une plage dynamique de décalage de phase symétrique par rapport à une valeur centrale de la plage de valeurs possibles pour le décalage fixe introduit par l'oscillateur 104. Par exemple, flock est choisie pour que le déphasage fixe introduit par l'oscillateur 104 entre Flock et Φsens soit égale à $\Pi/2$ quand la plage de valeurs possible de ce décalage de phase fixe va de 0 à $\Pi$.

L'oscillateur 104 est en outre commandé en tension. Plus exactement l'oscillateur 104 est un déphaseur contrôlé en tension.

Selon un mode de réalisation, l'oscillateur 104 est un oscillateur à relaxation comprenant une bascule RS, et, par exemple deux capacités ayant des tensions à leurs bornes qui déterminent les signaux sur les entrées de la bascule RS et des phases de charge et décharge commandées par les sorties de la bascule RS.

En figure 1, l'oscillateur 104 est commandé par une différence de tension DV entre la tension Vin à convertir et la tension Vfb de sortie de la boucle de contre réaction 102, c'est à dire la tension Vfb fournie par la boucle de contre réaction 102 et déterminée par la tension Vcp de sortie du circuit 108. Par exemple, la tensin Vfb est égale à la tension Vcp comme cela est illustré en figure 1. La tension DV de commande vient modifier la fréquence naturelle f0 de l'oscillateur 104, d'où il résulte un déphasage DΦ variable entre le signal Φsens fourni par l'oscillateur 104 et le signal Flock, qui dépend de la tension DV donc de la tension Vin. Dit autrement, la tension DV, donc la tension Vin, commande ou détermine le déphasage variable DΦ entre le signal Flock et le signal Φsens. Dans l'exemple de la figure 1, l'oscillateur 104 reçoit la tension DV comme tension de commande, cette dernière étant par exemple fournie par un circuit soustracteur comprenant un amplificateur opérationnel. Dans d'autres exemples, l'oscillateur 104 reçoit directement la tension Vin et la tension Vfb, et est commandé par ces deux tensions. Dit autrement, l'oscillateur 104 est configuré pour que le déphasage variable DΦ entre le signal Flock et le signal Φsens soit déterminé par la différence entre la tension Vin et la tension Vfb. Bien que dans l'exemple de la figure 1 le circuit 104 soit commandé directement par une différence, donc un écart, entre les tensions Vin et Vfb en recevant directement la tension DV, dans d'autres exemples, l'oscillateur 104 est commandé par un écart entre les tensions Vin et Vfb en recevant directement les tensions Vin et Vfb.

Un avantage de l'oscillateur 104 est que le déphasage DΦ varie linéairement avec la tension DV donc avec la tension Vin, le déphasage DΦ étant alors représentatif de, ou déterminé par, la valeur de la tension DV, donc la valeur de la tension Vin. Toutefois, lorsque les variations de la fréquence Vin sont trop rapides, c'est à dire que ces variations sont à des fréquences supérieures à la fréquence flock de verrouillage de l'oscillateur 104, ces variations sont filtrées par l'oscillateur 104, qui agit ou fonctionne alors comme un filtre passe bas de fréquence de coupure fc inférieure à flock. Ainsi, la fonction de transfert H2 de l'oscillateur 104 peut s'écrire H2 = K2/(1+(s/(2.Π.fc))), avec K2 le gain de l'oscillateur 104 et s la variable de Laplace.

Avec H1 = K1/s, la fonction de transfert H3 du convertisseur 1 peut s'écrire H3 = (K2.s)/(K1.K2 + s + (s²/(2.Π.fc))), la fréquence de résonance fres du convertisseur 1 étant alors définie par la relation suivante :

2.Π.fres = (K1.K2.2.n.fc)^0.5. Il en résulte le fonctionnement passe bande suivant du convertisseur 1.

Pour des variations de la tension Vin à des fréquences basses inférieures à la fréquence de résonance fres (ou fréquence centrale fres) du filtre passe bande, ou, dit autrement, pour s inférieure à 2.Π.fres, par exemple au moins dix fois inférieure à 2.Π.fres, les termes s et (s²/(2.Π.fc) sont considérés négligeables devant le terme K1.K2, et la fonction de transfert H3 est sensiblement égale à s/K1, ce qui correspond à la fonction de transfert d'un dérivateur, donc d'un filtre passe haut. En pratique, pour les fréquences basses, le signal Vin est compensé par la boucle de contre réaction 102 négative, et le signal de sortie out est fortement atténué.

Quand les fréquences des variations de la tension Vin deviennent supérieures la fréquence fc et se rapprochent de le fréquence fres, l'oscillateur 104 commence à atténuer le signal et à introduire un décalage de phase entre le signal Vin et le signal out jusqu'à ce que le signal out soit déphasé de Π/2 par rapport au signal Vin. Le signal out est fourni à la boucle de contre réaction 102 où le circuit 108 introduit un déphasage de -Π/2, mettant ainsi en oeuvre une contre réaction positive. Le signal out atteint un maximum à la fréquence de résonance fres du filtre passe bande, c'est à dire quand s est égale à 2.Π.fres, et la fonction de transfert H3 est alors égale au gain K2.

Pour des variations de la tension Vin ayant des fréquences supérieures à la fréquence de résonance fres du filtre, ou, dit autrement, pour s supérieur à 2.Π.fres, par exemple au moins dix fois supérieur à 2.Π.fres, les termes K1.K2 et s sont considérés négligeables devant le terme (s²/(2.Π.fc), et la fonction de transfert H3 est sensiblement égale à (K2.2.Π.fc)/s, ou encore, en remplaçant le terme 2.Π.fc par (2.Π.fres)²/(K1.K2), à ((2.Π.fres)²/K1)/s, ce qui correspond à la fonction de transfert d'un intégrateur, donc d'un filtre passe bas. En pratique, pour des fréquences supérieures à la fréquence fres, le gain du circuit 108 diminue en s'éloignant de la fréquence fres, le convertisseur 1 perd ses propriétés de boucle fermée et l'oscillateur 104 atténue le signal Vin.

Il en résulte que le convertisseur 1 se comporte bien comme un filtre passe bande dans lequel :

- la fréquence de résonance fres du filtre est égale à (K1.K2.2.Π.fc)^0.5/(2.Π) ;
- le dénominateur de la fonction de transfert H3 présente deux pôles qui peuvent être complexes, ce qui signifie que le facteur de qualité Q du filtre passe bande n'est pas limité à des valeurs inférieures à 0,5 ;
- le facteur de qualité Q est égal à (K1.K2/(2.Π.fc))^0,5, et peut donc être facilement choisi égal à des valeurs supérieures à 0,5 ;
- le gain à la fréquence fres correspond au gain K2, et est donc indépendant de la fréquence fres. Il en résulte que la fréquence fres peut être modifiée sans que cela ne modifie le gain du filtre passe bande ; et
- les opérations de conversion analogique vers durée et de filtrage passe bande sont mises en oeuvre en une seule étape, ce qui réduit la consommation et la complexité du convertisseur 1 par rapport à un circuit où l'opération de conversion analogique vers durée serait mise en oeuvre lors première étape et le filtrage passe bande serait mis en oeuvre lors d'une autre étape.

La figure 2 représente, sous la forme de blocs, un mode de réalisation plus détaillé du convertisseur 1 de la figure 1. Seules les différences entre le convertisseur 1 de la figure 1 et celui de la figure 2 sont ici décrites.

Plus particulièrement, la figure 2 illustre un mode de réalisation de circuits permettant de fournir le signal Flock et le signal Φ0.

Ainsi, en figure 2, le convertisseur 1 comprend un oscillateur à verrouillage en injection 200. Plus particulièrement, l'oscillateur 200 est par exemple un oscillateur à relaxation à verrouillage en injection. Cet oscillateur 200 est configuré pour recevoir le signal Flock comme signal de verrouillage, et pour fournir le signal Φ0, par exemple avec un déphasage par rapport au signal Flock configuré pour compenser le déphasage fixe introduit entre Flock et Φsens, par exemple avec un déphasage de Π/2 par rapport au signal Flock. Dit autrement, l'oscillateur 200 et le circuit 106 sont configurés pour compenser le déphasage fixe introduit par l'oscillateur 104 entre Flock et Φsens.

Selon un mode de réalisation, l'oscillateur 200 est un oscillateur à relaxation, par exemple un oscillateur à relaxation comprenant une bascule RS.

Selon un mode de réalisation, l'oscillateur 200 est similaire à l'oscillateur 104, à la différence qu'il n'est pas commandable en tension, ou, dit autrement, qu'il ne comprend pas les moyens de commande en tension que comprend l'oscillateur 104.

Par ailleurs, en figure 2, le convertisseur comprend un oscillateur 202 configuré pour fournir le signal Flock. Plus particulièrement, l'oscillateur 202 est par exemple un oscillateur dépourvu de la fonction de verrouillage en injection et de la fonction de commande en tension.

Selon un mode de réalisation, l'oscillateur 202 est un oscillateur à relaxation, par exemple un oscillateur à relaxation comprenant une bascule RS.

Selon un mode de réalisation, l'oscillateur 202 est similaire à l'oscillateur 104, à la différence qu'il n'est pas commandable en tension, ou, dit autrement, qu'il ne comprend pas les moyens de commande en tension que comprend l'oscillateur 104, et qu'il ne comprend pas les moyens, par exemple les composants, de verrouillage de la fréquence du signal Flock fourni par l'oscillateur 202 sur un signal de verrouillage à une fréquence de verrouillage.

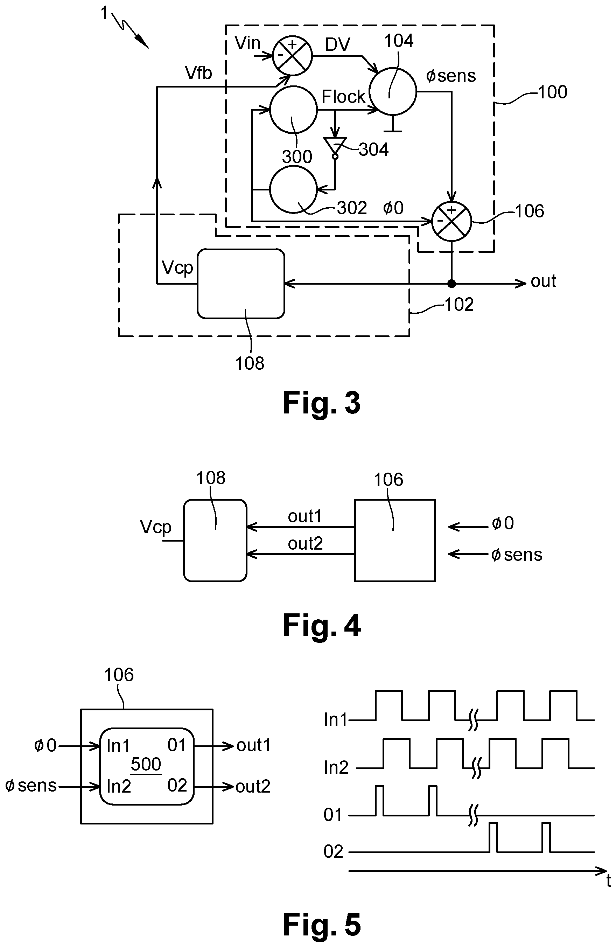

La figure 3 représente, sous la forme de blocs, une variante de réalisation du convertisseur 1 de la figure 2, et, plus particulièrement, une variante de réalisation de circuits permettant de fournir le signal Flock et le signal Φ0. Seules les différences entre les convertisseurs des figures 2 et 3 sont ici décrites.

Dans le convertisseur 1 de la figure 3, les oscillateurs 200 et 202 sont remplacés par deux oscillateurs identiques 300 et 302 rebouclés l'un sur l'autre et configurés pour fournir les deux signaux Flock et Φ0. Les oscillateurs 300 et 302 sont des oscillateurs à verrouillage en injection, par exemple dépourvus de la fonction de commande en tension.

Plus particulièrement, l'oscillateur 300 fournit le signal Flock à un inverseur 304, l'inverseur fournit un signal de sortie Flockb à l'oscillateur 302, l'oscillateur 302 fournissant le signal Φ0 l'oscillateur 300. Le signal Flockb sert donc de signal de verrouillage à l'oscillateur 300 et le signal Φ0 sert de signal de verrouillage à l'oscillateur 302.

Les oscillateurs 300 et 302 et l'inverseur 304 forment une structure appelée oscillateurs à verrouillage en injection auto-verrouillés.

Selon un mode de réalisation, chaque oscillateur 300, 302 est un oscillateur à relaxation, par exemple un oscillateur à relaxation comprenant une bascule RS.

Selon un mode de réalisation, chaque oscillateur 300, 302 est similaire à l'oscillateur 104, à la différence qu'il n'est pas commandable en tension, ou, dit autrement, qu'il ne comprend pas les moyens de commande en tension que comprend l'oscillateur 104.

La figure 4 représente, sous la forme de blocs, un mode de réalisation d'une partie du convertisseur 1 des figures 1 à 3, et, plus particulièrement, un mode de réalisation des circuits 106 et 108.

Dans ce mode de réalisation, le circuit 106 est configuré pour recevoir les signaux Φ0 et Φsens, et pour fournir deux signaux impulsionnels out1 et out2 représentatifs du déphasage entre les signaux Φ0 et Φsens. Dit autrement, en figure 4, le signal out comprend deux signaux impulsionnels out1 et out2.

A titre d'exemple plus particulier, lorsque le signal Φ0 est en avance de phase sur le signal Φsens, le circuit 106 est ici configuré pour fournir des impulsions out1. Le signal out2 est alors, de préférence, à un état de repos, c'est à dire qu'il ne présente pas d'impulsion. En outre, les impulsions out1 ont des durées déterminées par le déphasage entre les signaux Φ0 et Φsens. De manière symétrique, lorsque le signal Φsens est en avance de phase sur le signal Φ0, le circuit 106 est ici configuré pour fournir des impulsions out2. Le signal out1 est alors, de préférence, à un état de repos, c'est à dire qu'il ne présente pas d'impulsion. En outre, les impulsions out2 ont des durées déterminées par le déphasage entre les signaux Φ0 et Φsens.

Selon un mode de réalisation, le circuit 106 comprend un détecteur de phase (non représenté en figure 4). Par exemple, une entrée du détecteur de phase, par exemple une entrée In1 du détecteur de phase, est configurée pour recevoir un signal déterminé par le signal Φ0, par exemple le signal Φ0 lui-même, et une autre entrée du détecteur de phase, par exemple une entrée In2, est configurée pour recevoir un signal déterminé par le signal Φsens, par exemple le signal Φsens lui-même. Dit autrement, une entrée du détecteur de phase est commandée à partir du signal Φ0, l'autre entrée du détecteur de phase étant commandée à partir du signal Φsens. Une sortie du détecteur de phase, par exemple une sortie O1 activée par l'entrée In1, est configurée pour fournir le signal out1, une autre sortie du détecteur de phase, par exemple une sortie O2 activée par l'entrée In2, étant configurée pour fournir le signal out2.

Dans le mode de réalisation de la figure 4, le circuit 108 est configuré pour recevoir les signaux out1 et out2.

Selon un mode de réalisation, le circuit 108 est configurée pour fournir la tension Vcp de sorte que la tension Vcp varie linéairement dans un premier sens uniquement pendant la durée de chaque impulsion du signal out1, et varie

7

linéairement dans un deuxième sens opposé au premier uniquement pendant la durée de chaque impulsion du signal out2. De préférence, la pente de variation de la tension Vcp est, en valeur absolue, identique pour les premier et deuxième sens de variation. Le sens de variation de la tension Vcp en fonction des impulsions out1 et out2 reçues par le circuit 108 est déterminé de sorte que le rebouclage du chemin 102 sur l'entrée du chemin direct 100 (figure 1) mette en oeuvre une contre réaction négative. Plus généralement, le sens de variation de la tension Vfb de sortie de la boucle de contre réaction 102 en fonction du signal out de sortie du chemin direct 100 est configuré pour que le rebouclage du chemin 102 sur le chemin 100 mette en oeuvre une contre réaction négative.

Selon un mode de réalisation, le circuit 108 comprend une pompe de charge configurée pour recevoir les signaux out1 et out2, et pour fournir la tension Vcp à partir des signaux out1 et out2. Les signaux out1 et out2 sont alors des signaux de commande de la pompe de charge. La pompe de charge comprend par exemple deux sources de courant configurées pour respectivement charger et décharger une capacité, la tension Vcp étant disponible entre les bornes de la capacité, l'un des signaux out1 et out2 couplant sélectivement une première des deux sources de courant à la capacité, et l'autre des signaux out1 et out2 couplant sélectivement une deuxième des deux sources de courant à la capacité.

A titre d'exemple, lorsque le convertisseur 1 comprend un circuit configuré pour générer la tension DV en soustrayant la tension Vfb à la tension Vin, la tension Vcp augmente lors des impulsions out1, et diminue lors des impulsions out2. Dit autrement, les circuits 106 et 108 sont configurés pour que la tension Vcp augmente quand le signal Φ0 est en avance de phase par rapport au signal Φsens, et diminue quand le signal Φ0 est en retard de phase par rapport au signal Φsens. Cela permet, par exemple, que la boucle de contre réaction 102 soit une boucle de contre réaction négative. Dans d'autres exemples où l'oscillateur 104 n'est pas commandé directement par la tension DV mais à partir d'un écart entre les tensions Vfb et Vin, l'oscillateur recevant alors directement les tensions Vfb et Vin, pour que la boucle de contre réaction soit une boucle de contre réaction négative, les circuits 106 et 108 sont configurés pour que la tension Vcp diminue quand le signal Φ0 est en avance de phase par rapport au signal Φsens, et augmente quand le signal Φ0 est en retard de phase par rapport au signal Φsens.

La figure 5 représente un exemple de mise en oeuvre du circuit 106 de la figure 4 (à gauche en figure 5) et un exemple de fonctionnement du circuit 106 (à droite en figure 5) .

Dans cet exemple de mode de réalisation, le circuit 106 comprend un détecteur de phase tel que décrit précédemment et référencé 500 en figure 5, et, plus particulièrement, est mis en oeuvre uniquement par ce détecteur de phase 500.

Dans cet exemple, le détecteur de phase 500 reçoit le signal Φ0 sur son entrée In1, et le signal Φsens sur son entrée In2. Dans cet exemple, les entrées In1 et In2 sont active sur front montant, toutefois, dans d'autres exemples, ces entrées sont actives sur front descendant.

Le détecteur de phase 500 comprend les deux sorties O1 et O2 configurées, dans cet exemple, pour fournir les signaux respectivement out1 et out2.

Comme cela est illustrée par des chronogrammes à droite en figure 5, dans un état initial les entrées In1 et In2 sont à leur état bas, et les sorties O1 et O2 sont également à leur état bas.

A partir de l'état initial décrit ci-dessus, lorsqu'un front actif, ici montant, se présente sur l'entrée In1, cela provoque la commutation de la sortie O1, ici à l'état haut, la sortie O2 restant à son état courant, ici l'état bas. Puis, lorsqu'un front actif, ici montant, se présente sur l'entrée In2 alors que l'entrée In1 n'a pas encore commutée à son état initial, cela provoque la remise à l'état initial des deux sorties O1 et O2, c'est à dire ici que la sortie O1 commute à son état bas.

De manière symétrique, à partir de l'état initial, lorsqu'un front actif, ici montant, se présente sur l'entrée In2, cela provoque la commutation de la sortie O2, ici à l'état haut, la sortie O1 restant à son état courant, ici l'état bas. Puis, lorsqu'un front actif, ici montant, se présente sur l'entrée In1 alors que l'entrée In2 n'a pas encore commutée à son état initial, cela provoque la remise à l'état initial des deux sorties O1 et O2, c'est à dire ici que la sortie O2 commute à son état bas.

La sortie O1 est donc activée par l'entrée In1 et la sortie O2 est activée par l'entrée In2.

Dans d'autres exemples non illustrés, les états haut et bas des deux sorties O1 et O2 peuvent être inversés, c'est à dire que l'état initial des sorties O1 et O2 est l'état haut.

Bien entendu, la mise en oeuvre du circuit 106 ne se limite pas aux exemples décrits en relation avec les figures 4 et 5, et la personne du métier est en mesure, à partir de la description du fonctionnement du convertisseur 1 faite en relation avec les figures 1 à 3, de prévoir d'autres mises en oeuvre du circuit 106.

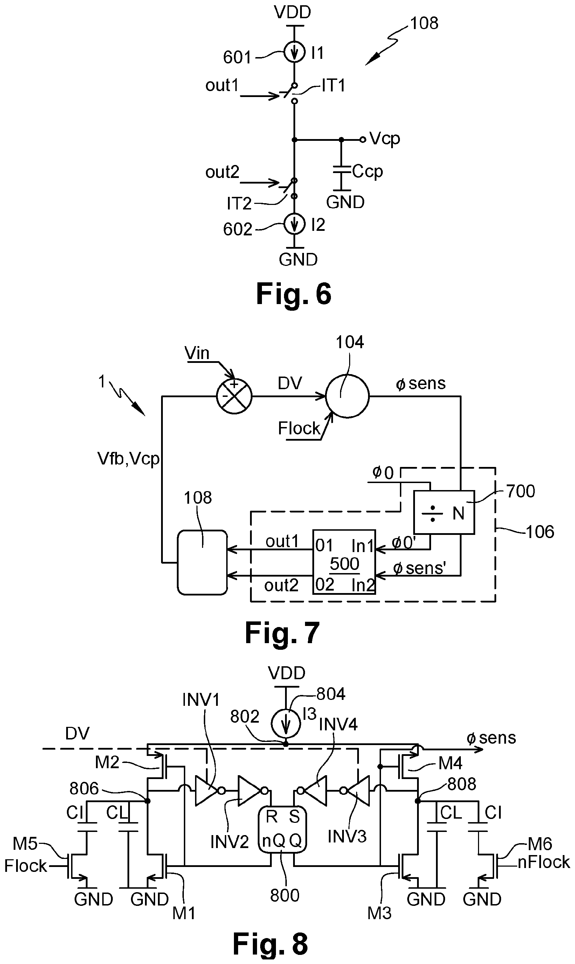

La figure 6 représente un exemple de mise en oeuvre du circuit 108 de la figure 4, par exemple dans le cas où le circuit 106 est mis en oeuvre de la façon illustré par la figure 5.

Dans cet exemple de mode de réalisation, le circuit 108 est mis en oeuvre par une pompe de charge.

La pompe de charge 108 comprend deux sources de courants 601 et 602 configurées pour délivrer des courants respectifs I1 et I2, deux interrupteurs IT1 et IT2 commandés par les signaux out1 et out2, par exemple respectivement par les signaux out2 et out1, et une capacité Ccp connectée entre une sortie du circuit 108 et, par exemple, la masse GND. La tension Vcp est disponible sur la sortie du circuit 108.

A titre d'exemple, la source de courant 601 est connectée entre un potentiel d'alimentation VDD, par exemple positif par rapport à la masse GND, et une borne de conduction de l'interrupteur IT1, l'autre borne de conduction de l'interrupteur IT1 étant connectée à la sortie du circuit 108, donc à la capacité Ccp. De manière symétrique, la source de courant 602 est connectée entre la masse GND et une borne de conduction de l'interrupteur IT2, l'autre borne de conduction de l'interrupteur IT2 étant connectée à la sortie du circuit 108, donc à la capacité Ccp. L'interrupteur IT1 est, dans cet exemple, commandé par le signal out1 et est configuré pour être passant à chaque impulsion du signal out1, c'est à dire à pendant chaque état haut du signal out1 dans cet exemple. De manière symétrique, l'interrupteur IT2 est, dans cet exemple, commandé par le signal out1 et est configuré pour être passant à chaque impulsion du signal out1, c'est à dire à pendant chaque état haut du signal out1 dans cet exemple.

Ainsi, dans cet exemple, la tension Vcp augmente à chaque impulsion du signal out1 (Φ0 en avance de phase sur Φsens) et diminue à chaque impulsion du signal out2 (Φ0 en retard de phase sur Φsens). Toutefois, comme cela a déjà été mentionné précédemment, pour que la boucle de contre réaction 102 mette en oeuvre une contre réaction négative, dans d'autres exemples la tension Vcp augmente à chaque impulsion du signal out2 (Φ0 en retard de phase sur Φsens) et diminue à chaque impulsion du signal out1 (Φ0 en avance de phase sur Φsens). Dans ces autres exemples, les interrupteurs IT1 et IT2 par exemple commandés respectivement par les signaux out1 et out2.

A titre d'exemple, dans le cas où I1 est égal à I2, la fonction de transfert H1 du circuit 108 peut s'écrire H1 = I1/(2.Π.Ccp.s), d'où il résulte que K1 est alors égal à I1/(2.Π.Ccp). On voit qu'il est alors facile de régler le gain K1 en modifiant le courant I1 et/ou la valeur de la capacité Ccp.

La figure 7 représente, sous la forme de blocs, une variante de réalisation du convertisseur 1 des figures 1 à 4, et, plus particulièrement, une variante de mise en oeuvre du circuit 106 par rapport au mode de réalisation décrit en relation avec la figue 5.

Dans cette variante de réalisation, le circuit 106 comprend un détecteur de phase, par exemple le détecteur de phase 500 décrit en relation avec la figure 5, et un diviseur de fréquence par N, référencé 700 en figure 7.

Le détecteur de phase 500 est commandé à partir des des signaux Φ0 et Φsens, par des signaux Φ0' et Φsens' obtenus, avec le circuit 700, en divisant par N la fréquence des signaux respectifs Φ0 et Φsens.

Le circuit 700 reçoit les signaux Φ0 et Φsens, et fournit les signaux respectifs Φ0' et Φsens' ayant une fréquence N fois plus faible que les signaux respectif Φ0 et Φsens.

A titre d'exemple, le signal Φ0' est reçu par l'entrée S et le signal Φsens' est reçu par l'entrée R.

Le circuit 700 permet d'augmenter le gain K1 de la boucle de contre réaction (ou chemin de retour) 102 (figure 1) par un facteur N.

La figure 8 représente un exemple de mode de réalisation de l'oscillateur 104 du convertisseur 1 des figures 1 à 4. Dans cet exemple de mode de réalisation, l'oscillateur est un oscillateur à relaxation comprenant une bascule de type RS 800. Le fonctionnement d'une bascule RS est bien connu de la personne du métier et ne sera pas détaillé ici. La bascule 800 comprend deux entrées S et R, et deux sorties Q et nQ activées par les entrées respectives S et R.

L'oscillateur 104 comprend deux interrupteurs M1 et M2 en série entre la masse GND et un noeud 802 couplé au potentiel d'alimentation VDD par une source de courant 804 délivrant un courant I3. Les deux interrupteurs M1 et M2 sont commandés en opposition de phase par la sortie nQ de la bascule 800. Dit autrement, lorsque les interrupteurs M1 et M2 sont deux transistors MOS, les transistors M1 et M2 ont des canaux de types opposés et ont leurs grilles couplées, de préférence connectées, à la sortie nQ. La source de courant 804 est, par exemple, connectée entre le noeud 802 et le potentiel VDD.

Dans cet exemple où le potentiel VDD est positif par rapport à la masse GND, le transistor M1 est à canal N et a sa source connectée à la masse GND, le transistor M2 est à canal P et a sa source connectée au noeud 802, et les transistors M1 et M2 ont leurs drains connectés à un même noeud 806.

De manière symétrique ou complémentaire, l'oscillateur 104 comprend deux interrupteurs M3 et M4 en série entre la masse GND et le noeud 802. Les deux interrupteurs M3 et M4 sont commandés en opposition de phase par la sortie Q de la bascule 800. Dit autrement, lorsque les interrupteurs M3 et M4 sont deux transistors MOS, les transistors M3 et M4 ont des canaux de types opposés et ont leurs grilles couplées, de préférence connectées, à la sortie Q.

Dans cet exemple où le potentiel VDD est positif par rapport à la masse GND, le transistor M3 est à canal N et a sa source connectée à la masse GND, le transistor M3 est à canal P et a sa source connectée au noeud 802, et les transistors M3 et M4 ont leurs drains connectés à un même noeud 808.

L'oscillateur 104 comprend une capacité CL connectée entre le noeud 806 et la masse GND. De manière symétrique ou complémentaire, l'oscillateur comprend une autre capacité CL connectée entre le noeud 808 et la masse GND.

L'oscillateur 104 comprend une capacité CI en série avec un interrupteur M5 entre le noeud 806 et la masse GND. L'interrupteur M5 est commandé par le signal Flock. L'interrupteur M5 est par exemple un transistor MOS. Dans cet exemple où VDD est positif par rapport à la masse GND, le transistor M5 est à canal N et a sa source couplée, par exemple connectée, à la masse GND, son drain étant couplé, par exemple connecté, au noeud 806.

De manière symétrique ou complémentaire, l'oscillateur 104 comprend une autre capacité CI en série avec un interrupteur M6 entre le noeud 808 et la masse GND. L'interrupteur M6 est commandé par un signal nFlock complémentaire du signal Flock. Dit autrement, le signal nFlock est à l'état haut, respectivement bas, quand le signal Flock est à l'état bas, respectivement haut. Dit encore autrement, les interrupteurs M5 et M6 sont commandés en opposition de phase à partir du signal Flock. L'interrupteur M6 est par exemple un transistor MOS. Dans cet exemple où VDD est positif par rapport à la masse GND, le transistor M6 est à canal N et a sa source couplée, par exemple connectée, à la masse GND, son drain étant couplé, par exemple connecté, au noeud 808.

L'entrée R de la bascule 800 est commandée à partir du signal disponible sur le noeud 806. Plus particulièrement, un nombre pair d'inverseurs en série couplent le noeud 806 à l'entrée R. De préférence, deux inverseurs INV1 et INV2 en série couplent le noeud 806 à l'entrée R. L'inverseur INV1 est connecté au noeud 806.

De manière symétrique ou complémentaire à ce qui vient d'être décrit, l'entrée S de la bascule 800 est commandée à partir du signal disponible sur le noeud 808. Plus particulièrement, un nombre pair d'inverseurs en série couplent le noeud 808 à l'entrée R. De préférence, deux inverseurs INV3 et INV4 en série couplent le noeud 808 à l'entrée S. L'inverseur INV3 est connecté au noeud 808.

En l'absence des capacités CI et des interrupteurs M5 et M6, le fonctionnement de l'oscillateur 104 est celui d'un oscillateur à relaxation comprenant une bascule RS, la bascule RS commandant les charges et décharges des capacités CL. Plus particulièrement, quand Q est à l'état bas, l'interrupteur M3 est ouvert et l'interrupteur M4 est passant, d'où il résulte que la capacité CL connectée au noeud 808 se charge grâce au courant I3. Lorsque la tension du noeud 808 atteint le seuil de commutation Vth de l'inverseur INV3, l'entrée S reçoit un front montant ce qui commute la sortie Q à l'état haut. Cela entraine que l'interrupteur M3 commute à l'état passant et que l'interrupteur M4 commute à l'état ouvert, et cela décharge la capacité CL connectée au noeud 808 vers la masse GND. De manière symétrique ou complémentaire, quand nQ est à l'état bas, l'interrupteur M1 est ouvert et l'interrupteur M2 est passant, d'où il résulte que la capacité CL connectée au noeud 806 se charge grâce au courant I3. Lorsque la tension du noeud 806 atteint le seuil de commutation Vth de l'inverseur INV1, l'entrée R reçoit un front montant ce qui commute la sortie nQ à l'état haut. Cela entraine que l'interrupteur M1 commute à l'état passant et que l'interrupteur M2 commute à l'état ouvert, et cela décharge la capacité CL connectée au noeud 806 vers la masse GND.

La sortie Φsens de l'oscillateur 104, qui correspond à la sortie Q de la bascule RS, oscille alors à la fréquence naturelle f0 de l'oscillateur 104. Dans cet exemple de mode de réalisation, la fréquence f0 peut s'écrire f0 = I3/(2.Vth.CL).

La prévision des capacités CI et des interrupteurs M5 et M6 dans l'oscillateur 104 comme cela est illustré en figure 8 permet de mettre en oeuvre la fonction de verrouillage en injection. Plus particulièrement, la valeur de chacune des capacité CL est modulée par la valeur de la capacité CI associée, à la fréquence flock du signal Flock. Il en résulte que le signal Φsens se met à osciller à la fréquence flock, avec un déphasage Φ fixe par rapport au signal Flock. Le déphasage Φ peut s'écrire Φ = Π.[1 + (1 + α) . ((flock/f0) - 1)], avec α égale à CLval/CIval, CLval étant la valeur de chaque capacité CL et CIval étant la valeur de chaque capacité CI.

En pratique le déphase Φ est compris entre 0 et Π. Ainsi, la plage de verrouillage dans laquelle doit se trouver la fréquence flock pour que l'oscillateur 104 se verrouiller sur cette fréquence s'étend de α.f0/(1+α), qui correspond à un déphasage Φ nul, à f0 qui correspond à un déphasage Φ de Π. Selon un mode de réalisation, la fréquence flock est choisie au milieu de la plage de verrouillage de l'oscillateur 104, et correspond donc à un déphasage Φ de Π/2.

De manière symétrique, la sortie de l'oscillateur 104 peut être prise sur la sortie nQ de la bascule plutôt que sur sa sortie Q, d'où il résulte que le décalage fixe Φ entre Flock et Φsens appartient alors à une plage allant de -Π quand flock est égale à α.f0/(1+α), à 0 quand flock égale f0. Dans ce cas, flock est de préférence choisie de sorte que le décalage fixe Φ introduit par l'oscillateur 104 entre Flock et Φsens soit égal à -Π/2. La personne du métier sera en mesure d'adapter la description à cet exemple.

L'oscillateur 104 est un déphaseur commandé en tension, par exemple par la différence de tension DV. Pour cela, comme cela est représenté par des traits en pointillés en figure 8, la tension est utilisée pour moduler le seuil Vth de commutation des inverseurs INV1 et INV3 connectés aux noeuds respectifs 806 et 808. Par exemple, la tension DV est appliquée au substrat de chacun des inverseurs INV1 et INV3, d'où il résulte que le seuil Vth de chacun des inverseurs peut s'écrire Vth = Vth0 + Kinv.DV, avec Kinv le gain de l'inverseur et Vth0 le seuil de commutation de l'inverseur en l'absence de tension DV). A titre d'exemple, le gain Kinv est négatif (le seuil Vth varie de manière opposée à la tension DV) .

La fréquence de coupure fc de l'oscillateur 104 peut alors être approximée par le ratio flock/(Π.α), et son gain K2 par α.Kinv.Π/(Vth0).

Dans l'exemple de la figure 8, l'oscillateur 104, et, plus particulièrement les inverseurs INV1 et INV3, reçoivent la tension DV égale à la différence entre la tension Vin et la tension Vfb, de sorte que l'oscillateur 104 soit commandé par la différence entre la tension Vin et la tension Vfb. Cela implique que le convertisseur 1 comprend un circuit configuré pour recevoir les tensions Vfb et Vin et pour fournir la tension DV.

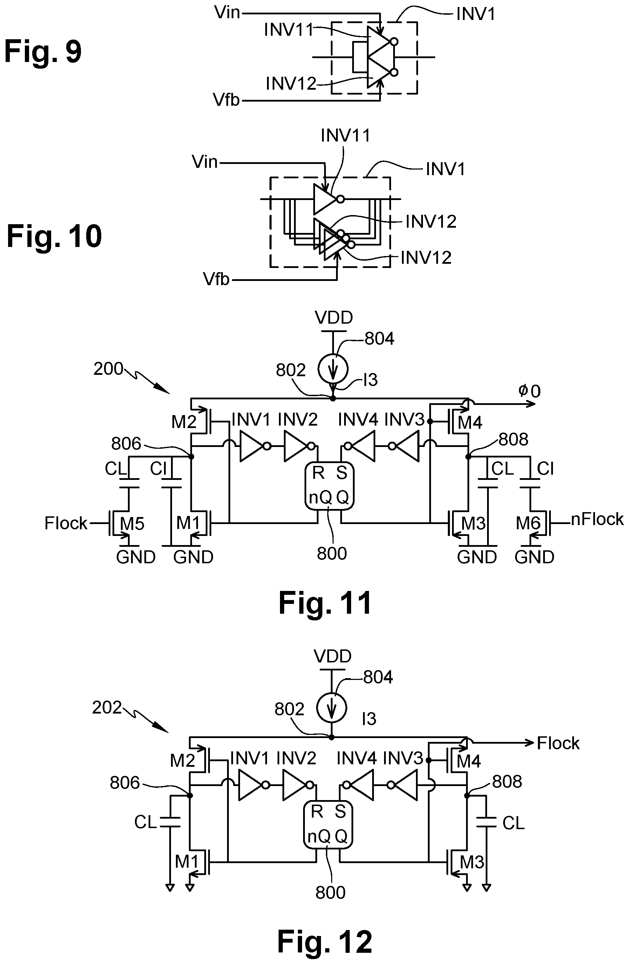

Toutefois, comme cela a déjà été indiqué en relation avec la figure 1, l'oscillateur 104 peut recevoir les deux tensions Vin et Vfb plutôt que la tension DV, et être configuré pour être commandé par la différence entre la tension Vin et la tension Vfb, par exemple comme cela va maintenant être décrit en relation avec la figure 9.

La figure 9 illustre une variante de réalisation de l'oscillateur 104 à verrouillage en injection et à commande en tension décrit en relation avec la figure 8, dans le cas où l'oscillateur reçoit les deux tensions Vin et Vfb plutôt que la tension DV. En figure 9, l'oscillateur 104 diffère de celui de la figure 8 uniquement par la mise en oeuvre des inverseurs INV1 et INV3. Seul l'inverseur INV1 est représenté en figure 9, l'inverseur INV3 étant mis en oeuvre de la même façon et le reste de l'oscillateur 104 étant similaire ou identique à ce qui a été décrit en relation avec la figure 8.

Dans cette variante, l'inverseur INV1 est mis en oeuvre par un inverseur INV11 et un inverseur INV12. Les deux inverseurs INV11 et INV12 sont connectés en parallèle, ou, dit autrement, ont leurs entrées connectées entre elles et leurs sorties connectées entre elles.

L'inverseur INV1 (délimité par des traits en pointillé en figure 9) est configuré pour recevoir les deux tensions Vin et Vfb. Plus particulièrement, l'inverseur INV11 est configuré pour recevoir la tension Vin et l'inverseur INV12 est configuré pour recevoir la tension Vfb.

Comme l'inverseur INV1 décrit en relation avec la figure 8 qui est configuré pour que la tension DV module son seuil de commutation Vth, l'inverseur INV11, respectivement INV12, est configuré pour que la tension Vin, respectivement Vfb, module son seuil de commutation. Par exemple, la tension Vin est appliqué au substrat de l'inverseur INV11 et la tension Vfb est appliquée au substrat de l'inverseur INV12.

Les inverseurs INV11 et INV12 sont configurés pour que la modulation des seuils des inverseurs INV11 et INV12 par les tensions respectives Vin et Vfb résulte en une modulation du seuil Vth de l'inverseur INV1 similaire à la modulation du seuil Vth de l'inverseur INV1 directement par la tension DV, par exemple une modulation identique à un facteur de gain près qui dépend du nombre d'inverseurs utilisés pour mettre en oeuvre l'inverseur INV1. Par exemple, en considérant que l'inverseur INV1 décrit en relation avec la figure 8 est identique à chacun des inverseurs INV11 et INV12 décrits en relation avec la figure 9, alors le gain de l'inverseur INV1 de la figure 9 sera deux fois plus faible que le gain de l'inverseur INV1 de la figure 8.

A titre d'exemple, lorsque les inverseurs INV1 et INV3 sont mis en oeuvre de la façon décrite en relation avec la figure 9, et que les circuits 106 et 108 sont mis en oeuvre de la façon décrite en relation avec les figures 4 à 6, pour que les inverseurs INV1 et INV3 mettent en oeuvre de façon implicite la soustraction de la tension Vfb à la tension Vin, il suffit d'inverser la connexion des signaux out1 et out2 aux interrupteurs IT1 et IT2 de la pompe de charge 108, de sorte que la tension Vcp diminue lors des impulsions out1, et augmente lors des impulsions out2. Dit autrement, les circuits 106 et 108 sont alors configurés pour que la tension Vcp augmente quand le signal Φ0 est en retard de phase par rapport au signal Φsens, et diminue quand le signal Φ0 est en avance de phase par rapport au signal Φsens. Cela permet, par exemple, que la boucle de contre réaction 102 soit une boucle de contre réaction négative.

La figure 10 illustre une variante de réalisation de l'oscillateur 104 à verrouillage en injection et à commande en tension décrit en relation avec la figure 8, dans le cas où l'oscillateur reçoit les deux tensions Vin et Vfb plutôt que la tension DV. En figure 10, l'oscillateur 104 diffère de celui de la figure 8 uniquement par la mise en oeuvre des inverseurs INV1 et INV3. Seul l'inverseur INV1 est représenté en figure 10, l'inverseur INV3 étant mis en oeuvre de la même façon et le reste de l'oscillateur 104 étant similaire ou identique à ce qui a été décrit en relation avec la figure 8.

Plus particulièrement, en figure 10, la mise en oeuvre de l'inverseur INV1 diffère de celle décrite en relation avec la figure 9 en ce que l'inverseur INV1 comprend plusieurs inverseurs INV12 connecté en parallèle et ayant chacun leur seuil de commutation modulé par la tension Vfb.

De cette façon, le gain de boucle ouverte du convertisseur 1 est divisé par rapport au gain de boucle fermée, par un facteur G dépendant du nombre d'inverseurs INV12. Dit autrement, cela revient à avoir un gain de boucle fermé G fois plus grand que le gain en boucle ouverte. Cela revient conceptuellement à ajouter un étage de gain G entre la tension Vcp et la tension Vfb.

La figure 11 représente un exemple de mode de réalisation d'un oscillateur à verrouillage en injection sans commande en tension, par exemple de l'oscillateur 200 de la figure 2.

L'oscillateur 200 de la figure 11 diffère de l'oscillateur 104 de la figure 8 en ce qu'il n'est pas commandable en tension, donc qu'il ne comprend les moyens relatifs à cette commande en tension.

Ainsi, l'oscillateur 200 de la figure 11 diffère de l'oscillateur 104 de la figure 8 uniquement en ce que le seuil Vth de commutation des inverseurs INV1 et INV3 n'est pas commandable en tension, ni par la tension DV, ni par les deux tension Vin et Vfb.

Bien que la figure 11 illustre l'oscillateur 200 de la figure 2, chacun des oscillateurs 300, 302 de la figure 3 peut être mis en oeuvre de la même façon que l'oscillateur 200 de la figure 2, en adaptant, si besoin, les signaux de commande des interrupteurs M6 et M7, et le signal de sortie disponible sur la sortie Q de la bascule 800.

La figure 12 représente un exemple de mode de réalisation d'un oscillateur à relaxation, sans verrouillage en injection et sans commande en tension, par exemple de l'oscillateur 202 de la figure 2.

L'oscillateur 202 de la figure 12 diffère de l'oscillateur 104 de la figure 8 en ce qu'il ne comprend pas les moyens de commande en tension des seuils de commutation des inverseurs INV1 et INV3, et qu'il ne comprend pas les moyens (ou composant) pour la mise en oeuvre du verrouillage en injection, c'est à dire les composants CI, M5 et M6. Dit d'une autre façon, l'oscillateur 202 de la figure 12 diffère de l'oscillateur 200 de la figure 11 en ce qu'il ne comprend pas moyens (ou composant) pour la mise en oeuvre du verrouillage en injection, c'est à dire les composants CI, M5 et M6.

La valeur ClockVal des capacités CL de l'oscillateur 202 de la figure 12 est adaptée par rapport à celle des capacités CL des oscillateurs 200 et 104, de sorte que la fréquence naturelle flock de l'oscillateur 200 soit dans la plage de verrouillage de l'oscillateur 104.

Selon un exemple particulier de mode de réalisation, l'oscillateur 104 est mis en oeuvre de la façon décrite en relation avec la figure 8 et la fréquence flock est choisie au milieu de la plage de verrouillage de l'oscillateur 104, d'où il résulte que la valeur ClockVal peut s'écrire ClockVal = CLval.((1 + $\alpha$) / (0,5 + $\alpha$)).

Selon un exemple particulier de mode de réalisation, les oscillateurs 104, 200 et 202 du convertisseur 1 de la figure 2 sont mis en oeuvre de la façon décrite en relation avec les figures 8, 11 et 13, avec un contrôle des seuils de commutation des inverseurs INV1 et INV3 tel que décrit en relation avec la figure 9, et les circuits 106 et 108 sont mis en oeuvre de la façon décrite en relation avec les figures 5 et 6, en adaptant la connexion du circuit 106 et 108 au contrôle des inverseurs INV1 et INV3 par les deux tensions Vin et Vfb. Dans un tel exemple :

- la fréquence de résonnance fres du convertisseur 1 s'écrire :

[Math 1]

$$fres \approx \frac{1}{2\Pi}\sqrt{\frac{Kinv.(I1.I3)}{2.Vth0.CcpVal.ClockVal}} = \frac{A}{2\Pi}\sqrt{(I1.I3)}$$

avec CcpVal la valeur de capacité de la capacité Ccp de la pompe de la charge 108 et A un facteur constant déterminé par Kinv, Vth0, CcpVal et ClockVal ;
- le facteur de qualité Q du convertisseur 1 peut s'écrire :

[Math 2]

$$Q \approx \alpha.\sqrt{\frac{Kinv.ClockVal.I1}{2.CcpVal.I3}} = B.\alpha$$

en rendant les courants I1 et I3 égaux ; et
- le gain Gconv du convertisseur peut s'écrire :

[Math 3]

$$Gconv = \frac{\alpha.\Pi.Kinv}{Vth0}$$

On voit que, dans l'exemple particulier ci-dessus, lorsque le courant I1 et I3 sont égaux, la valeur de la fréquence de résonnance fres varie linéairement avec le courant I1, et une modification du courant I1 (donc du courant I2 égale à I1 et du courant I3 égale à I1) ne modifie pas Q et Gconv. En outre, fres est indépendante de $\alpha$, et $\alpha$ peut être utilisé pour modifier le facteur de qualité Q qui dépend linéairement de $\alpha$.

Dans les modes de réalisation et variantes de réalisation décrits ci-dessus du convertisseur 1, la tension Vin est par exemple une tension simple rail, c'est à dire une tension non différentielle. Toutefois, la personne du métier est en mesure d'adapter la description faite ci-dessus a des exemples dans lesquels la tension Vin est l'une des deux composantes Vn et Vp d'une tension différentielle Vindiff, par exemple en prévoyant un convertisseur analogique-durée comprenant le convertisseur 1 pour convertir la tension Vin, c'est à dire la première composante Vn de tension Vindiff, et au moins un autre oscillateur 104' identique à l'oscillateur 104 et un autre circuit intégrateur 108' identique au circuit 108 pour convertir la deuxième composante Vp de la tension Vindiff.

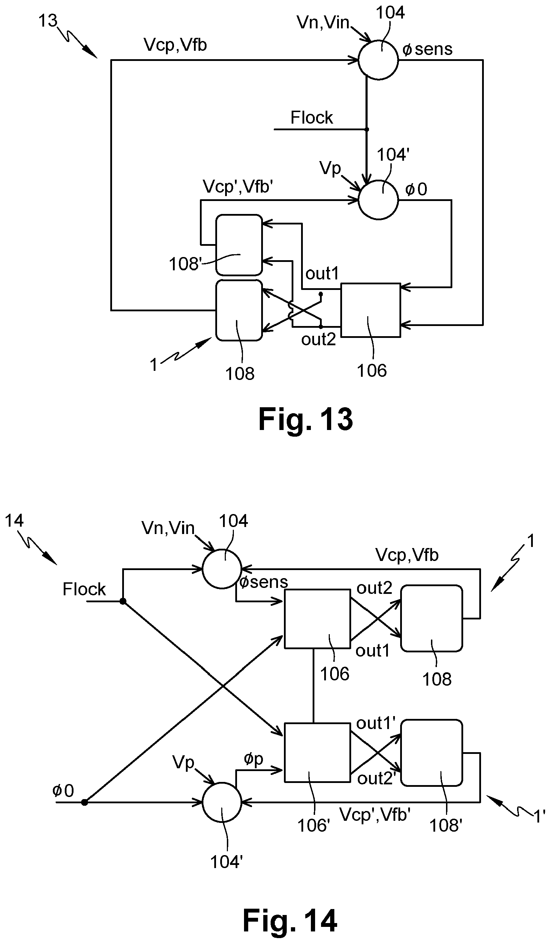

La figure 13 représente un mode de réalisation d'un convertisseur 13 analogique-durée à filtre passe bande comprenant le convertisseur 1, dans le cas où la tension Vin est la première composante Vn d'une tension Vindiff.

Plus particulièrement, dans ce mode de réalisation, le convertisseur 13 comprend, en plus du convertisseur 1, c'est à dire en plus de l'oscillateur 104, du circuit 106 et du circuit 108, l'oscillateur 104' et le circuit 108'.

Le circuit 108' est configuré pour intégrer le signal impulsionnel out, c'est à dire les signaux out1 et out2 dans l'exemple de la figure 13. Par exemple, le circuit 108' est configuré pour intégrer les signaux out1 et out2 de manière complémentaire à l'intégration de ces signaux faite par le circuit 108. Par exemple, cela revient à ce que l'interrupteur IT1 du circuit 108' soit commandé par celui des signaux out1 et out2 qui commande l'interrupteur IT2 du circuit 108, et que l'interrupteur IT2 du circuit 108' soit commandé par celui des signaux out1 et out2 qui commande l'interrupteur IT1 du circuit 108. Le circuit 108' fourni alors un signal de sortie Vcp', qui détermine un signal de contre réaction Vfb', le signal Vfb' étant, par exemple, égal au signal Vcp' dans l'exemple de la figure 13.

L'oscillateur 104' est configuré pour fournir le signal Φ0, de sorte que le déphasage entre le signal Φ0 et le signal Flock soit déterminé par une différence de tension entre la tension Vp et la tension Vfb'.

Le signal out de sortie du circuit 106, c'est à dire les signaux out1 et out2 dans l'exemple de la figure 13, sont alors représentatif non seulement de la conversion analogique vers durée de la tension Vin, mais également plus largement de la conversion analogique numérique de la tension Vindiff.

La personne du métier est en mesure d'adapter les diverses variantes de réalisation décrites en relation avec les figures 1 à 12 au convertisseur 13 de la figure 13.

La figure 14 représente un autre mode de réalisation d'un convertisseur 14 analogique-durée à filtre passe bande comprenant le convertisseur 1, dans le cas où la tension Vin est la première composante Vn d'une tension Vindiff.

Plus particulièrement, dans ce mode de réalisation, le convertisseur 13 comprend, en plus du convertisseur 1 comprenant l'oscillateur 104, le circuit 106 et le circuit 108, un convertisseur 1' similaire au convertisseur 1, le convertisseur 1 comprenant un oscillateur 104' identique à l'oscillateur 104, un circuit 106' identique au circuit 106 et un circuit 108' identique au circuit 108.

En pratique, le convertisseur 1' met en oeuvre la conversion de la tension Vp, c'est à dire de la deuxième composante de la tension Vindiff, en une durée, de manière similaire au convertisseur 1 qui met en oeuvre la conversion de la tension Vin, c'est à dire la première composante Vn de la tension Vindiff, en durée.

Ainsi, dans ce mode de réalisation, le circuit 106' est configuré pour recevoir un signal de sortie Φp de l'oscillateur 104 et le signal Flock, et pour fournir au moins un signal impulsionnel de sortie, par exemple deux signaux out1' et out2' dans l'exemple de la figure 14, déterminés par un déphasage entre le signal Flock et le signal Φp.

Le circuit 108' est configuré pour intégrer le ou les signaux de sortie du circuit 106', par exemple les signaux out1' et out2' dans l'exemple de la figure 14, de manière similaire à la façon dont le circuit 108 intègre le signal de sortie du circuit 106.

L'oscillateur 104' est configuré pour recevoir le signal Φ0. Plus particulièrement, l'oscillateur 104' reçoit le signal Φ0 là où l'oscillateur 104 reçoit le signal Flock, d'où il résulte que l'oscillateur 104' est verrouillé sur le signal Φ0 plutôt que sur le signal Flock. L'oscillateur 104' est en outre configurée pour que le déphasage entre son signal de sortie Φp et le signal Φ0 soit déterminé par une différence de tension entre la composante Vp et une tension Vfb' de contre réaction déterminée par la tension de sortie Vcp' du circuit 108', par exemple de manière similaire à la façon dont l'oscillateur 104 est configuré pour que le déphasage entre son signal de sortie et le signal Flock soit déterminé par la différence de tension DV entre la tension Vin (composante Vn) et la tension Vfb déterminée par la tension Vcp.

Ainsi, les signaux out1, out2, out1' et out2' sont représentatif de la conversion de la tension Vindiff en durée par le convertisseur 14.

A titre d'exemple, dans le convertisseur 14, les signaux Flock et Φ0 sont fournis par deux oscillateurs 300 et 302 rebouclés l'un sur l'autre au moyen d'un inverseur 304 comme cela a été décrit en relation avec la figure 3.

La personne du métier est mesure d'adapter les variantes de réalisation décrites précédemment pour le convertisseur 1 au convertisseur 14 de la figure 14.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus, en particulier en ce qui concerne le sens de variation des signaux Vcp, Vfb, en fonction de la façon dont sont mises en oeuvre les commandes de l'oscillateurs 104 à partir de ces signaux et de la façon dont varie le déphasage entre Φsens et Flock avec le signal Vin et les signaux Vin, Vcp et Vfb. Dit autrement, la personne du métier est en mesure d'adapter la connexion entre les circuits constituants le convertisseur 1 en fonction du signe du gain introduit par chacun de ces circuits de sorte que le rebouclage du chemin de retour 102 sur le chemin direct 100 mette en oeuvre une contre réaction négative. Par exemple, dans des modes de réalisation, la tension Vcp diminue lorsque le signal Φ0 est en avance de phase sur Φsens et augmente à lorsque le signal Φ0 est en retard de phase sur Φsens.

**Revendications**

1. Convertisseur (1 ; 13 ; 14) d'une tension (Vin) en durée, le convertisseur comprenant :

un chemin direct (100) comprenant un premier oscillateur (104) à verrouillage en injection et un premier circuit (106), le premier circuit étant configuré pour recevoir un signal de sortie ($\Phi$sens) du premier oscillateur et un signal de référence ($\Phi$0), et pour fournir au moins un premier signal impulsionnel (out ; out1, out2) déterminé par un déphasage entre le signal de sortie ($\Phi$sens) du premier oscillateur et le signal de référence ($\Phi$0) ; et une boucle de contre réaction (102) comprenant un deuxième circuit (108) configuré pour intégrer ledit au moins un premier signal impulsionnel (out ; out1, out2),

dans lequel le premier oscillateur (104) est configuré pour être commandé par un écart entre la tension à convertir (Vin) et une tension de sortie (Vfb) de la boucle de contre réaction (102), la tension de sortie (Vfb) de la boucle de contre réaction (102) étant déterminée par une tension de sortie (Vcp) du deuxième circuit (108) représentative de l'intégration dudit au moins un premier signal impulsionnel (out ; out1, out2), la boucle de contre réaction (102) et le chemin direct (100) étant, par exemple, configurée pour qu'un rebouclage de la boucle de contre réaction (102) sur le chemin direct (100) mette en oeuvre une contre réaction négative.

2. Convertisseur (1 ; 13 ; 14) selon la revendication 1, dans lequel le premier oscillateur est un déphaseur contrôlé en tension.

3. Convertisseur (1 ; 13 ; 14) selon la revendication 1 ou 2, dans lequel ledit au moins un premier signal impulsionnel (out ; out1, out2) comprend des impulsions ayant chacune une durée déterminée par le déphasage entre le signal de sortie ($\Phi$sens) du premier oscillateur (104) et le signal de référence ($\Phi$0) .

4. Convertisseur (1 ; 13 ; 14) selon l'une quelconque des revendications 1 à 3, dans lequel :
le premier oscillateur (104) est configuré pour recevoir un signal périodique (Flock) à une fréquence de verrouillage du premier oscillateur (104), et pour que ledit écart de tension (DV) détermine un déphasage entre le signal de sortie ($\Phi$sens) du premier oscillateur (104) et le signal périodique (Flock).

5. Convertisseur selon la revendication 4, dans lequel le signal de référence ($\Phi$0) et le premier circuit (106) sont configurés pour compenser un déphasage fixe introduit par le premier oscillateur (104) entre le signal périodique (Flock) à la fréquence de verrouillage et le signal de sortie ($\Phi$sens) du premier oscillateur (104).

6. Convertisseur (1 ; 13 ; 14) selon la revendication 4, dans lequel le convertisseur comprend un deuxième oscillateur (200) à verrouillage en injection configuré pour recevoir le signal périodique (Flock) et pour fournir le signal de référence ($\Phi$0) .

7. Convertisseur (1 ; 13 ; 14) selon la revendication 4, dans lequel le convertisseur comprend deux deuxièmes oscillateurs identiques (300, 302) à verrouillage en injection rebouclés l'un sur l'autre et configurés pour fournir le signal périodique (Flock) et le signal de référence ($\Phi$0) .

8. Convertisseur (13) selon la revendication 4, dans lequel : la tension à convertir (Vin) est une première composante (Vn) d'un signal différentiel comprenant une deuxième composante (Vp) ;

le convertisseur (13) comprend en outre un troisième circuit (108') identique au deuxième circuit (108), configuré pour intégrer ledit au moins un premier signal impulsionnel (out1, out2), de préférence de manière de manière complémentaire par rapport au deuxième circuit (108) ; et
le convertisseur (13) comprend un deuxième oscillateur (104') à verrouillage en injection identique au premier oscillateur (104), le deuxième oscillateur (104') étant configuré pour fournir le signal de référence ($\Phi$0) et pour qu'une différence de tension entre la deuxième composante (Vp) et une tension (Vfb') déterminée par une tension de sortie (Vcp') du troisième circuit (108') détermine un déphasage entre le signal de référence ($\Phi$0) et le premier signal périodique (Flock).

9. Convertisseur (14) selon la revendication 4, dans lequel :

la tension à convertir (Vin) est une première composante (Vn) d'un signal différentiel comprenant une deuxième composante (Vp) ;
le convertisseur (14) comprend un deuxième oscillateur à verrouillage en injection (104') et un troisième circuit (108'), le troisième circuit (106') étant configuré pour recevoir un signal de sortie ($\Phi$p) du deuxième oscillateur (104') et le signal périodique (Flock), et pour fournir au moins un deuxième signal impulsionnel (out1', out2') déterminé par un déphasage entre le signal de sortie ($\Phi$p) du deuxième oscillateur (104') et le signal périodique (Flock) ;
le convertisseur (14) comprend un quatrième circuit (108') configuré pour intégrer ledit au moins un deuxième signal impulsionnel (out1', out2') ; et
le deuxième oscillateur (104') est configuré pour recevoir le signal de référence (Φ0) et pour qu'un déphasage entre son signal de sortie (Φp) et le signal de référence (Φ0) soit déterminé par une différence de tension entre la deuxième composante (Vp) et une tension (Vfb') déterminée par une tension de sortie (Vcp') du quatrième circuit (108').

10. Convertisseur selon la revendication 9, dans lequel le convertisseur (14) comprend deux troisièmes oscillateurs (300, 302) à verrouillage en injection identiques, rebouclés l'un sur l'autre et configurés pour fournir le signal périodique (Flock) et le signal de référence (Φ0) avec un déphasage de Π/2 par rapport au signal périodique (Flock).

11. Convertisseur selon la revendication 9 ou 10, dans lequel :

les premier et deuxième oscillateurs (104, 104') sont identiques ;
les premier et troisième circuits (106, 106') sont identiques ; et
les deuxième et quatrième circuits (108, 108') sont identiques.

12. Convertisseur (1 ; 13 ; 14) selon l'une quelconque des revendications 4 à 11, dans lequel le convertisseur est configuré pour que la fréquence de verrouillage soit au milieu d'une plage de verrouillage du premier oscillateur (104) .

13. Convertisseur (1 ; 13 ; 14) selon l'une quelconque des revendications 1 à 12, dans lequel :

ledit au moins un premier signal impulsionnel (out) comprend deux premiers signaux impulsionnels (out1, out2) ;
le premier circuit (106) comprend un détecteur de phase configuré pour fournir les deux premiers signaux impulsionnels (out1, out2).

14. Convertisseur (1 ; 13 ; 14) selon l'une quelconque des revendications 1 à 13, dans lequel le deuxième circuit (108) est une pompe de charge.

15. Convertisseur (1 ; 13 ; 14) selon l'une quelconque des revendications 1 à 14, dans lequel chaque oscillateur (104, 200, 202, 300, 302, 104') est un oscillateur à relaxation comprenant une bascule RS configurée pour commander des phases de charge et de décharge dans deux capacités (CL), et pour être commander à partir des tensions aux bornes desdites deux capacités.

**Patentansprüche**

1. Ein Wandler (1; 13; 14) zum Wandeln einer Spannung (Vin) in Zeit, wobei der Wandler Folgendes aufweist:

einen Vorwärtspfad (100) aufweisend einen ersten injektionsverriegelten Oszillator (104) und eine erste Schaltung (106), wobei die erste Schaltung konfiguriert ist zum Empfangen eines Ausgangssignals (Φsens) von dem ersten Oszillator und eines Referenzsignals (Φ0), und zum Liefern wenigstens eines ersten Impulssignals (out; out1, out2), bestimmt durch eine Phasenverschiebung zwischen dem Ausgangssignal (Φsens) des ersten Oszillators und dem Referenzsignal (Φ0); und
eine Rückkopplungsschleife (102) aufweisend eine zweite Schaltung (108) konfiguriert zum Integrieren des wenigstens einen ersten Impulssignals (out; out1, out2),
wobei der erste Oszillator (104) konfiguriert ist, um gesteuert zu werden durch eine Differenz zwischen der umzuwandelnden Spannung (Vin) und einer Ausgangsspannung (Vfb) der Rückkopplungsschleife (102), wobei die Ausgangsspannung (Vfb) der Rückkopplungsschleife (102) bestimmt wird durch eine Ausgangsspannung (Vcp) der zweiten Schaltung (108), die repräsentativ ist für die Integration des wenigstens einen ersten Impulssignals (out; out1, out2),
wobei die Rückkopplungsschleife (102) und der Vorwärtspfad (100) beispielsweise konfiguriert sind, so dass eine Rückkopplung der Rückkopplungsschleife (102) auf den Vorwärtspfad (100) eine negative Rückkopplung implementiert.

2. Der Wandler (1; 13; 14) nach Anspruch 1, wobei der erste Oszillator ein spannungsgesteuerter Phasenschieber ist.

3. Der Wandler (1; 13; 14) nach Anspruch 1 oder 2, wobei das wenigstens eine erste Impulssignal (out; out1, out2) Impulse aufweist, die jeweils eine Dauer haben, die durch die Phasenverschiebung zwischen dem Ausgangssignal (Φsens) des ersten Oszillators (104) und dem Referenzsignal (Φ0) bestimmt ist.

4. Der Wandler (1; 13; 14) nach einem der Ansprüche 1 bis 3, wobei:
der erste Oszillator (104) konfiguriert ist zum Empfangen eines periodischen Signals (Flock) bei einer Verriegelungsfrequenz des ersten Oszillators (104), und für die Spannungsdifferenz (DV) zum Bestimmen einer Phasenverschiebung zwischen dem Ausgangssignal (Φsens) des ersten Oszillators (104) und dem periodischen Signal (Flock).

5. Der Wandler nach Anspruch 4, wobei das Referenzsignal (Φ0) und die erste Schaltung (106) konfiguriert sind zum Kompensieren einer festen Phasenverschiebung, die durch den ersten Oszillator (104) zwischen dem periodischen Signal (Flock) bei der Sperrfrequenz und dem Ausgangssignal (Φsens) des ersten Oszillators (104) verursacht wird.

6. Der Wandler (1; 13; 14) nach Anspruch 4, wobei der Wandler einen zweiten injektionsverriegelten Oszillator (200) aufweist, der konfiguriert ist zum Empfangen des periodischen Signals (Flock) und zum Liefern des Referenzsignals (Φ0).

7. Der Wandler (1; 13; 14) nach Anspruch 4, wobei der Wandler zwei identische zweite injektionsverriegelte Oszillatoren (300, 302) aufweist, die miteinander rückgekoppelt sind und konfiguriert sind zum Liefern des periodischen Signals (Flock) und des Referenzsignals (Φ0).

8. Der Wandler (13) nach Anspruch 4, wobei:

   die umzuwandelnde Spannung (Vin) eine erste Komponente (Vn) eines Differenzsignals ist, das eine zweite Komponente (Vp) aufweist;
   der Wandler (13) ferner eine dritte Schaltung (108') aufweist, identisch mit der zweiten Schaltung (108), konfiguriert zum Integrieren des wenigstens einen ersten Impulssignals (out1, out2), vorzugsweise in einer komplementären Weise bezüglich der zweiten Schaltung (108); und
   der Wandler (13) einen zweiten injektionsverriegelten Oszillator (104') aufweist, identisch mit dem ersten Oszillator (104), wobei der zweite Oszillator (104') konfiguriert ist zum Liefern des Referenzsignals (Φ0) und derart, dass eine Spannungsdifferenz zwischen der zweiten Komponente (Vp) und einer Spannung (Vfb'), bestimmt durch eine Ausgangsspannung (Vcp') der dritten Schaltung (108'), eine Phasenverschiebung zwischen dem Referenzsignal (Φ0) und dem ersten periodischen Signal (Flock) bestimmt.

9. Der Wandler (14) nach Anspruch 4, wobei:

   die umzuwandelnde Spannung (Vin) eine erste Komponente (Vn) eines Differenzsignals ist, das eine zweite Komponente (Vp) aufweist;
   der Wandler (14) einen zweiten injektionsverriegelten Oszillator (104') und eine dritte Schaltung (108') aufweist, wobei die dritte Schaltung (106') konfiguriert ist zum Empfangen eines Ausgangssignals (Φp) von dem zweiten Oszillator (104') und des periodischen Signals (Flock) und zum Liefern wenigstens eines zweiten Impulssignals (out1', out2'), das durch eine Phasenverschiebung zwischen dem Ausgangssignal (Φp) des zweiten Oszillators (104') und dem periodischen Signal (Flock) bestimmt ist;
   der Wandler (14) eine vierte Schaltung (108') aufweist, konfiguriert zum Integrieren des wenigstens einen zweiten Impulssignals (out1', out2'); und
   der zweite Oszillator (104') konfiguriert ist zum Empfangen des Referenzsignals (Φ0) und derart, dass eine Phasenverschiebung zwischen seinem Ausgangssignal (Φp) und dem Referenzsignal (Φ0) bestimmt ist durch eine Spannungsdifferenz zwischen der zweiten Komponente (Vp) und einer Spannung (Vfb'), die durch eine Ausgangsspannung (Vcp') der vierten Schaltung (108') bestimmt ist.

10. Der Wandler nach Anspruch 9, wobei der Wandler (14) zwei identische dritte injektionsverriegelte Oszillatoren (300, 302) aufweist, die übereinander rückgekoppelt und konfiguriert sind zum Liefern des periodischen Signals (Flock) und des Referenzsignals (Φ0) mit einer Phasenverschiebung von $\Pi/2$ bezüglich des periodischen Signals (Flock).

11. Der Wandler nach Anspruch 9 oder 10, wobei:

   der erste und der zweite Oszillator (104, 104') identisch sind;
   die erste und die dritte Schaltung (106, 106') identisch sind; und
   die zweite und vierte Schaltung (108, 108') identisch sind.

**12.** Der Wandler (1; 13; 14) nach einem der Ansprüche 4 bis 11, wobei der Wandler konfiguriert ist, so dass die Verriegelungsfrequenz in der Mitte eines Verriegelungsbereichs des ersten Oszillators (104) liegt.

**13.** Der Wandler (1; 13; 14) nach einem der Ansprüche 1 bis 12, wobei:

das wenigstens eine erste Impulssignal (out) zwei erste Impulssignale (out1, out2) aufweist;
die erste Schaltung (106) einen Phasendetektor aufweist, konfiguriert zum Liefern der ersten beiden Impulssignale (out1, out2).

**14.** Der Wandler (1; 13; 14) nach einem der Ansprüche 1 bis 13, wobei die zweite Schaltung (108) eine Ladungspumpe ist.

**15.** Der Wandler (1; 13; 14) nach einem der Ansprüche 1 bis 14, wobei jeder Oszillator (104, 200, 202, 300, 302, 104') ein Relaxationsoszillator ist aufweisend ein RS-Flipflop, konfiguriert zum Steuern von Lade- und Entladephasen in zwei Kondensatoren (CL), und um basierend auf den Spannungen über die zwei Kondensatoren gesteuert zu werden.

**Claims**

**1.** A converter (1; 13; 14) for converting a voltage (Vin) into time, the converter comprising:

a forward path (100) comprising a first injection-locked oscillator (104) and a first circuit (106), the first circuit being configured for receiving an output signal ($\Phi$sens) from the first oscillator and a reference signal ($\Phi$0), and for providing at least a first pulse signal (out; out1, out2) determined by a phase shift between the output signal ($\Phi$sens) of the first oscillator and the reference signal ($\Phi$0); and
a feedback loop (102) comprising a second circuit (108) configured for integrating said at least one first pulse signal (out; out1, out2),
wherein the first oscillator (104) is configured for being controlled by a difference between the voltage to be converted (Vin) and an output voltage (Vfb) of the feedback loop (102), the output voltage (Vfb) of the feedback loop (102) being determined by an output voltage (Vcp) of the second circuit (108) representative of the integration of said at least one first pulse signal (out; out1, out2), the feedback loop (102) and the forward path (100) being, for example, configured so that a loopback of the feedback loop (102) on the forward path (100) implements a negative feedback.

**2.** The converter (1; 13; 14) according to claim 1, wherein the first oscillator is a voltage-controlled phase shifter.

**3.** The converter (1; 13; 14) according to claim 1 or 2, wherein said at least one first pulse signal (out; out1, out2) comprises pulses each having a duration determined by the phase shift between the output signal ($\Phi$sens) of the first oscillator (104) and the reference signal ($\Phi$0).

**4.** The converter (1; 13; 14) according to any of claims 1 to 3, wherein:
the first oscillator (104) is configured for receiving a periodic signal (Flock) at a locking frequency of the first oscillator (104), and for said voltage difference (DV) to determine a phase shift between the output signal ($\Phi$sens) of the first oscillator (104) and the periodic signal (Flock).

**5.** The converter according to claim 4, wherein the reference signal ($\Phi$0) and the first circuit (106) are configured for compensating for a fixed phase shift caused by the first oscillator (104) between the periodic signal (Flock) at the locking frequency and the output signal ($\Phi$sens) of the first oscillator (104).

**6.** The converter (1; 13; 14) according to claim 4, wherein the converter comprises a second injection-locked oscillator (200) configured for receiving the periodic signal (Flock) and for providing the reference signal ($\Phi$0).

**7.** The converter (1; 13; 14) according to claim 4, wherein the converter comprises two identical second injection-locked oscillators (300, 302) looped back on one another and configured for providing the periodic signal (Flock) and the reference signal ($\Phi$0).

**8.** The converter (13) according to claim 4, wherein:

the voltage to be converted (Vin) is a first component (Vn) of a differential signal comprising a second component (Vp) ; the converter (13) further comprises a third circuit (108') identical to the second circuit (108), configured for integrating the at least one first pulse signal (out1, out2), preferentially in a complementary manner with respect to the second circuit (108); and

the converter (13) comprises a second injection-locked oscillator (104') identical to the first oscillator (104), the second oscillator (104') being configured for providing the reference signal ($\Phi$0) and such that a voltage difference between the second component (Vp) and a voltage (Vfb') determined by an output voltage (Vcp') of the third circuit (108') determines a phase shift between the reference signal ($\Phi$0) and the first periodic signal (Flock).

9. The converter (14) according to claim 4, wherein:

the voltage to be converted (Vin) is a first component (Vn) of a differential signal comprising a second component (Vp) ; the converter (14) comprises a second injection-locked oscillator (104') and a third circuit (108'), the third circuit (106') being configured for receiving an output signal ($\Phi$p) from the second oscillator (104') and the periodic signal (Flock), and for providing at least one second pulse signal (out1', out2') determined by a phase shift between the output signal ($\Phi$p) of the second oscillator (104') and the periodic signal (Flock);

the converter (14) comprises a fourth circuit (108') configured for integrating said at least one second pulse signal (out1', out2'); and

the second oscillator (104') is configured for receiving the reference signal ($\Phi$0) and such that a phase shift between the output signal ($\Phi$p) thereof and the reference signal ($\Phi$0) is determined by a voltage difference between the second component (Vp) and a voltage (Vfb') determined by an output voltage (Vcp') of the fourth circuit (108').

10. The converter according to claim 9, wherein the converter (14) comprises two identical third injection-locked oscillators (300, 302) looped back one over another and configured for providing the periodic signal (Flock) and the reference signal ($\Phi$0) with a phase shift of $\Pi$/2 with respect to the periodic signal (Flock).

11. The converter according to claim 9 or 10, wherein:
the first and second oscillators (104, 104') are identical; the first and third circuits (106, 106') are identical; and the second and fourth circuits (108, 108') are identical.

12. The converter (1; 13; 14) according to any of claims 4 to 11, wherein the converter is configured so that the locking frequency is in the middle of a locking range of the first oscillator (104).

13. The converter (1; 13; 14) according to any of claims 1 to 12, wherein:

said at least one first pulse signal (out) comprises two first pulse signals (out1, out2);
the first circuit (106) comprises a phase detector configured for providing the first two pulse signals (out1, out2) .

14. The converter (1; 13; 14) according to any of claims 1 to 13, wherein the second circuit (108) is a charge pump.

15. The converter (1; 13; 14) according to any of claims 1 to 14, wherein each oscillator (104, 200, 202, 300, 302, 104') is a relaxation oscillator comprising an RS flip-flop configured for controlling charging and discharging phases in two capacitors (CL), and for being controlled on the basis of the voltages across said two capacitors.

**Fig. 1**

**Fig. 2**

**Fig. 3**

**Fig. 4**

**Fig. 5**

**Fig. 6**

**Fig. 7**

**Fig. 8**

**Fig. 9**

**Fig. 10**

**Fig. 11**

**Fig. 12**

**Fig. 13**

**Fig. 14**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **DE GUTIERREZ et al.** Time-encoding-based ultra-low power features extraction circuit for speech recognition tasks. *Electronics (Switzerland),* vol. 9 (3

- **DE KIM et al.** A 23 $\mu$w Solar-Powered Keyword-Spotting ASIC with Ring-Oscillator-Based Time-Domain Feature Extraction. *IEEE Solid-State Circuits Conférence,* 2022
- **DE GOUX et al.** A 6-nW 0.0013-mm ILO Bandpass Filter for Time-Based Feature Extraction. *IEEE Solid-State Circuits Letters,* vol. 3, 306-309